Europäisches Patentamt

European Patent Office

Office européen des brevets

(11) Publication number: **0 404 308
A2**

# EUROPEAN PATENT APPLICATION

(21) Application number: **90304423.8**

(51) Int. Cl.⁵: **H01S 3/107**

(22) Date of filing: **25.04.90**

(30) Priority: **23.06.89 JP 159434/89**

(43) Date of publication of application:
**27.12.90 Bulletin 90/52**

(84) Designated Contracting States:
**DE FR GB**

(71) Applicant: **KOKUSAI DENSHIN DENWA CO.,
LTD**
**3-2, Nishi-shinjuku 2-Chome
Shinjuku-ku Tokyo(JP)**

(72) Inventor: **Ryu, Shiro**

**1-113, 16, Suwazaka, Tsurumi-ku
Yokohama-shi, Kanagawa-ken(JP)**
Inventor: **Mochizuki, Kiyofumi**
**43-4, Kitanodai 3-chome
Hachioji-shi, Tokyo(JP)**
Inventor: **Wakabayashi, Hiroharu**
**35-3, Minamiikuta 6-chome, Tama-ku
Kawasaki-shi, Kanagawa-ken(JP)**

(74) Representative: **Higgins, Michael Roger et al
A.R. Davies & Co. 27, Imperial Square
Cheltenham Glos. GL50 1RQ(GB)**

(54) **Semiconductor laser light source device.**

(57) Semiconductor laser light source device comprises a semiconductor laser unit(1), which is a DFB laser unit(1′), a lens(2) as a light coilimator, and an external cavity(20) comprising a light phase modulator(16) having a high-reflectance coating film(19) on the end of the modulator(16) opposite the semiconductor laser unit(1).

A rearward emitted light(L2) emitted rearward from the semiconductor laser unit(1), which also emits output light (L1) forward, is entered into the light phase modulator (16) through the lens(2) and then reflected as returned light(L3) to the laser unit(1) by the high-reflectance coating film(19) so that the linewidth of the spectrum of the semiconductor laser light source device is made small.

The phase of the light in the external cavity(20) constituted by the light phase modulator(16) is changed by a data signal (E1) applied to the electrode(13) thereof, so that the frequency of the forward output light(L1) is altered.

## Fig.1

Xerox Copy Centre

## BACKGROUND OF THE INVENTION

The present invention relates to a semiconductor laser light source device in which a semiconductor laser and an external cavity are combined with each other so that the linewidth of the spectrum of output light from the device is made small.

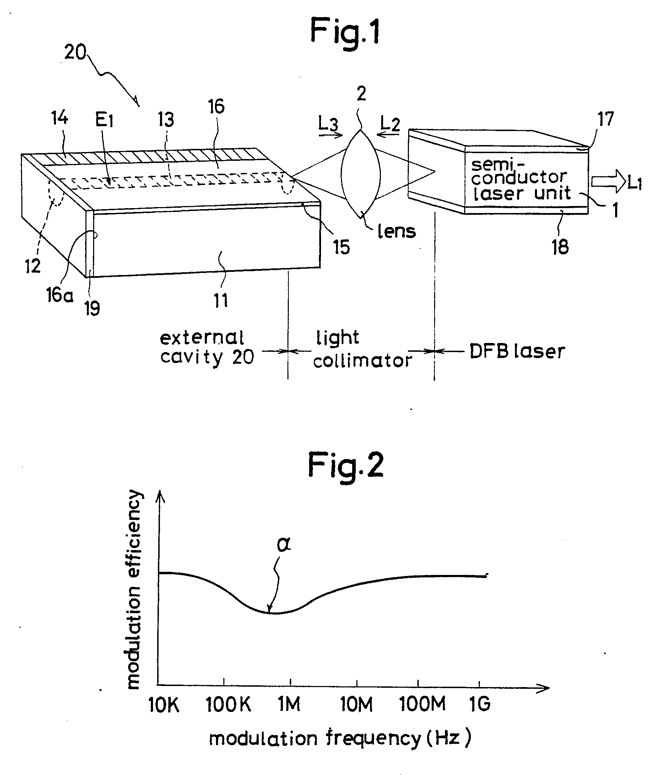

Light modulation methods for a coherent light communication system are of the amplitude shift keying type, the frequency shift keying type, the phase shift keying and so forth. In the light modulation method of the frequency shift keying type, light can be modulated in a relatively simple manner by directly modulating a driving current for a semiconductor laser light source device and a high receiver sensitivity can be achieved. For that reason, the light modulation method of the frequency shift keying type is likely to be widely used in the future. However, the light modulation method of the frequency shift keying type has two major problems which have hindered putting the method into practical use. The first major problem is about the purity of the spectrum of output light from the semiconductor laser light source device. Although the linewidth of the spectrum needs to be about several hundreds of kilohertz to about several megahertz to make the receiver sensitivity high in the light modulation method of the frequency shift keying type, the linewidth of the spectrum of output light from a DFB laser light source device manufactured usually is about ten megahertz to about scores of megahertz and therefore hinders making the receiver sensitivity high in the method. The second major problem is the nonuniformity of the direct frequency modulation characteristic of the semiconductor laser light source device to the frequency. The nonuniformity results from the fact that the direct frequency modulation in the semiconductor laser light source is affected by the temperature thereof in the low range of the frequency and by the change in the density of carriers therein in the high range of the frequency. An example of the nonuniformity is a dip $\alpha$ around the frequency at which the influence of the temperature and that of the change in the density begin to decrease, as shown in FIG. 2. Since an NRZ signal which is a data signal has a large number of low frequency components, a frequency shift keying signal obtained as a result of the modulation has a distortion which deteriorates the characteristic of transmission for communication.

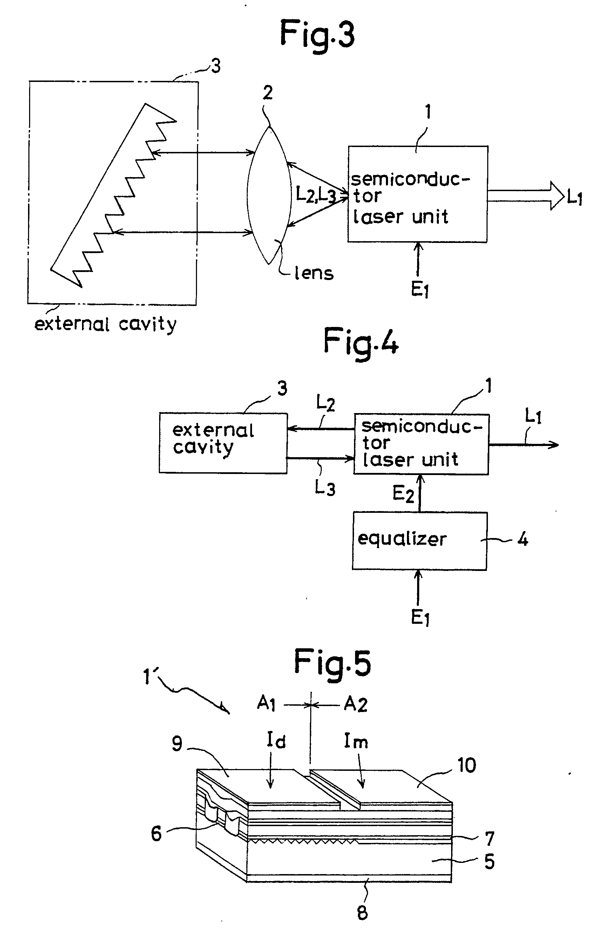

To cope with the first problem, a method in which a lens 2 for collimating rearward emitted light L2 from a semiconductor laser unit 1, which emits forward output light L1 and the rearward emitted light, and an external cavity 3 such as a filter, which reflects only light of prescribed wavelength, are provided behind the semiconductor laser unit, as shown in FIG. 3, and the position of the cavity is changed to reduce the linewidth of the spectrum of the output light has been widely practiced. However, since the position of the external cavity 3 is mechanically changed, there is a problem that frequency modulation cannot be performed by altering the length of the cavity. Besides, there is another problem that the flatness of the characteristic curve of the frequency modulation is bad. This is the second major problem mentioned above.

To cope with the problems of the method which has been widely practiced, a method in which a data signal E1 for modulation is equalized by an equalizer 4 whose characteristic is inverse to the frequency modulation characteristic of a semiconductor laser unit 1 and the modulation is performed by an equalized data signal E2 obtained as a result of the equalization, as shown in FIG. 4, has been proposed.

To make it unnecessary to provide the equalizer 4, a DFB laser light source device 1' having a phase control section A2 as shown in FIG. 5 has been proposed as published by S. Yamazaki et al. in No. 7, Vol. 21, Electronics Letters, March, 1985. In the device 1', a DFB section A1 having an active layer 6 and the phase control section A2 having a light waveguide layer 7 are integrated with each other on the same substrate 5. An electrode 8 is provided on one side of the device 1'. Other electrodes 9 and 10 are provided in the DFB section A1 and the phase control section A2, respectively, on another side of the device 1'. The phase of the phase control section A2 is changed by an electrical current Im injected into the section through the electrode 10, so that the flatness of the characteristic curve of frequency modulation is made good. Shown at Id in FIG. 5 is a data signal current.

However, a conventional semiconductor laser light source device shown in FIG. 4 and having an external cavity 3 and the equalizer 4 has a problem that it is extremely difficult to design an electric circuit which constitutes the equalizer. Besides, the device has another problem that the equalizer 4 needs to be designed in accordance with each of semiconductor laser units minutely different from each other in direct frequency modulation characteristic.

Since the conventional DFB laser light source device shown in FIG. 5 and having the phase control section A2 does not have an external cavity, the device has a problem that the linewidth of the spectrum of output light from the device is as large as about ten megahertz to about scores of megahertz. Since the frequency modulation is performed through the change in the density of carriers, the device has another problem that the bandwidth of the frequency modulation is restricted by the carrier lifetime so as to have a bandwidth of about 200 MHz to about 300 MHz.

For these reasons, it is impossible as to each of the conventional semiconductor laser light source devices to make the linewidth of the spectrum of output light therefrom, the flatness of the characteristic curve of direct frequency modulation therein and the bandwidth of the modulation small, good and wide, respectively.

## SUMMARY OF THE INVENTION

The present invention seeks to overcome the above mentioned drawbacks of the conventional semiconductor laser light source devices.

Accordingly, the present invention seeks to provide a semiconductor laser light source device in which the linewidth of the spectrum of output light from the device is small, the flatness of the characteristic curve of direct frequency modulation in the device is good, and the bandwidth of the modulation is wide.

According to the present invention, there is provided a semiconductor laser light source device in which a part of light emitted from a semiconductor laser unit is fed back thereto by an external cavity so that the linewidth of the spectrum of output light from said unit is made small, wherein said cavity and a modulation means are included; said cavity is constituted by a light phase modulator in which the electrooptical effect that the refractive index of said modulator is changed by a voltage applied thereto is produced; said modulator is provided with a high reflectance coating film on the end of said modulator opposite said semiconductor laser unit; said modulation means is for modulating said voltage; and phase modulation is permitted in said cavity so that the linewidth of the spectrum of the output light emitted from the semiconductor laser unit opposite the cavity is made small and the frequency modulation is performed at the same time. Rearward emitted light emitted rearward from the semiconductor laser unit is entered into the light phase modulator and reflected as returned light to the unit by the high-reflectance coating film on the end of the modulator opposite the unit so that the linewidth of the spectrum of the output light from the unit is made small. The phase of the light in the light phase modulator is changed by a data signal applied to the electrode of the modulator, so that the frequency of the output light, which is emitted forward from the semiconductor laser unit, is altered.

The semiconductor laser unit and the external cavity can be integrated with each other to enhance the reliability of the semiconductor laser light source device and reduce the size thereof. The external resonator can be made of $LiNbO_3$ in a

simple manner. The device can be widely applied to light modulation methods of the frequency shift keying type for coherent light communication optical fiber systems.

## DESCRIPTION OF THE DRAWINGS

FIG. 1 is a perspective view of a semiconductor laser light source device which is an embodiment of the present invention;

FIG. 2 is a graph showing the characteristic curve of direct frequency modulation in a conventional semiconductor laser light source device;

FIG. 3 is a block diagram of another conventional semiconductor laser light source device having an external cavity;

FIG. 4 is a block diagram of yet another conventional semiconductor laser light source device having an external cavity and an equalizer; and

FIG. 5 is a perspective view of a conventional DFB laser light source device having a phase control section.

## DETAILED DESCRIPTION OF EXEMPLARY EMBODIMENT

An embodiment of the present invention is hereafter described in detail with reference to FIG. 1. The embodiment is a semiconductor laser light source device. Portions shown in FIG. 1 and equivalent to those shown in FIGS. 3, 4 and 5 are denoted by the same reference symbols as the latter and not repeatedly described in detail, hereinafter.

FIG. 1 shows the semiconductor laser light source device comprising a semiconductor laser unit 1, a lens 2, a substrate 11 made of $LiNbO_3$ , a light waveguide layer 12 including titanium diffused therein, electrodes 13 and 14, and a buffer layer 15 for reducing the absorption of light by the electrode 13. A light phase modulator 16 is composed of the substrate 11, the light waveguide layer 12, the electrodes 13 and 14, and the buffer layer 15. Electrodes 17 and 18 are provided at the top and bottom of the semiconductor laser unit 1. The light phase modulator 16 has a high-reflectance coating film 19 on the end of the modulator opposite the semiconductor laser unit 1. The film 19 acts so that rearward emitted light L2 emitted rearward from the semiconductor laser unit 1 is reflected as returned light to the laser unit. The light phase modulator 16 constitutes the external cavity 20 of the semiconductor laser light source device. In other words, the device comprises the semiconductor laser unit 1, which is a DFB laser unit, the lens 2 as a light collimator, and the external cavity 20.

For example, the light phase modulator 16 is made of an electrooptical crystal of lithium niobate or LiNbO $_3$. The light phase modulator 16 made of a ferromagnetic substance such as the lithium niobate has such a wide bandwidth of frequency modulation that the frequency modulation can be performed in a range of several gigahertz bandwidth. Besides, the flatness of the characteristic curve of the frequency modulation is good.

The rearward emitted light L2 emitted rearward from the semiconductor laser unit 1, which also emits output light L1 forward, is entered into the light phase modulator 16 through the lens 2 and then reflected as returned light to the laser unit by the highreflectance coating film 19 so that the linewidth of the spectrum of the semiconductor laser light source device is made small.

The phase of the light in the external cavity 20 constituted by the light phase modulator 16 is changed by a data signal E1 applied to the electrode 13 thereof, so that the frequency of the forward output light L1 is altered.

## Claims

1. A semiconductor laser light source device in which a part of light emitted from a semiconductor laser unit is fed back thereto by an external cavity so that the linewidth of the spectrum of output light from said unit is made small, wherein said cavity and a modulation means are included; said cavity is constituted by a light phase modulator in which the electrooptical effect that the refractive index of said modulator is changed by a voltage applied thereto is produced; said modulator is provided with a high reflectance coating film on the end of said modulator opposite said semiconductor laser unit; said modulation means is for modulating said voltage; and phase modulation is performed in said cavity so that the linewidth of the spectrum of said output light emitted from said unit opposite said cavity is made small and frequency modulation is performed at the same time.

2. A semiconductor laser light source device according to the claim 1, wherein the external modulator is made of lithium niobate expressed as LiNbO$_3$ .

# Fig.1

external cavity 20 — light collimator — DFB laser

# Fig.2

# Fig.3

external cavity

# Fig.4

# Fig.5